(19) Europäisches Patentamt
European Patent Office
Office européen des brevets

(11) **EP 2 044 816 B1**

(12) **FASCICULE DE BREVET EUROPEEN**

(45) Date de publication et mention de la délivrance du brevet:
**01.06.2016 Bulletin 2016/22**

(21) Numéro de dépôt: **07765802.9**

(22) Date de dépôt: **04.07.2007**

(51) Int Cl.:
*H05H 1/46* (2006.01)      *H01J 37/32* (2006.01)

(86) Numéro de dépôt international:
**PCT/EP2007/056760**

(87) Numéro de publication internationale:
**WO 2008/009559 (24.01.2008 Gazette 2008/04)**

(54) **DISPOSITIF ET PROCÉDÉ DE PRODUCTION ET/OU DE CONFINEMENT D'UN PLASMA**

VORRICHTUNG UND VERFAHREN ZUM PRODUZIEREN UND/ODER EINGRENZEN EINES PLASMAS

DEVICE AND METHOD FOR PRODUCING AND/ OR CONFINING A PLASMA

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **21.07.2006 FR 0606680**

(43) Date de publication de la demande:
**08.04.2009 Bulletin 2009/15**

(73) Titulaires:
• **Centre National de la Recherche Scientifique (CNRS)**
**75016 Paris (FR)**
• **Université Joseph Fourier - Grenoble 1**
**38400 Saint-Martin-d'Hères (FR)**

(72) Inventeurs:
• **PELLETIER, Jacques**
**F-38400 Saint Martin D'Heres (FR)**
• **LACOSTE, Ana**
**F-38950 Saint Martin Le Vinoux (FR)**
• **BECHU, Stéphane**
**F-38470 Chantesse (FR)**

(74) Mandataire: **Regimbeau**
**20, rue de Chazelles**
**75847 Paris Cedex 17 (FR)**

(56) Documents cités:
**FR-A- 2 840 451      US-A- 6 022 446**
**US-A1- 2005 194 910**

## Description

DOMAINE GENERAL DE L'INVENTION

L'invention concerne un dispositif de production et/ou de confinement d'un plasma, comportant une enceinte dans le volume de laquelle le plasma est produit ou confiné, ladite enceinte comprenant une paroi définissant une enveloppe intérieure à l'enceinte et englobant le volume.

L'invention concerne également un procédé de production et/ou de confinement d'un plasma.

ETAT DE L'ART

Le confinement des plasmas dans un volume par des aimants permanents est utilisé depuis de nombreuses années de manière universelle, en raison de l'accroissement des performances qu'il permet en termes de densité et d'uniformité du plasma.

Depuis 1974, la technique n'a pas évolué, puisque le confinement du plasma est réalisé de manière générale en plaçant à la périphérie du volume de confinement, à l'intérieur ou à l'extérieur des parois de l'enceinte, des aimants permanents présentant au plasma des polarités nord et sud alternées, d'où le nom de confinement magnétique multipolaire.

Dès 1975, une étude a été effectuée afin de déterminer le meilleur arrangement et la distance optimale entre aimants permanents. Cette étude a montré que c'était les structures continues en ligne, et non les structures en échiquier ou en ligne interrompue, qui procuraient le meilleur confinement. Par contre, la distance entre aimants, qui présente un maximum relativement plat, semble moins critique.

Enfin, en 1992, la meilleure connaissance des mécanismes de confinement magnétique multipolaire permit de proposer, pour améliorer l'efficacité du confinement, de refermer les structures magnétiques multipolaires sur elles-mêmes à la manière des structures "magnétron".

Le principe du confinement multipolaire du plasma, et en particulier des électrons qui produisent le plasma, semble désormais bien connu. En effet, les particules chargées qui rentrent dans la région d'influence d'un champ magnétique multipolaire :

1) soit sont réfléchies par ce champ magnétique et sont renvoyées dans la région exempte de champ magnétique d'où elles étaient issues (mécanisme que l'on appellera « mécanisme 1 »);
2) soit franchissent en totalité la région de champ magnétique dans les régions où leur trajectoire est presque parallèle aux lignes de champ magnétiques, puisqu'il n'y a pas alors couplage entre la particule chargée et le champ magnétique (mécanisme que l'on appellera « mécanisme 2 »). C'est le cas des particules chargées qui arrivent de la zone sans champ magnétique, soit directement vers le pôle des aimants, soit directement dans la zone de champ magnétique d'intensité nulle située entre deux aimants de même polarité (cas des aimants unitaires alternés);
3) soit sont piégées dans le champ magnétique multipolaire par mécanisme collisionnel (mécanisme que l'on appellera « mécanisme 3 »).

Autrement dit, les seules particules chargées qui sont perdues pour le plasma sont :

- d'une part celles qui sont piégées sur des lignes de champ (*mécanisme* 3) qui traversent des surfaces matérielles, et
- d'autre part celles qui arrivent depuis le volume exempt de champ magnétique vers les régions de convergence des lignes de champ magnétique (*mécanisme 2*)*,* c'est-à-dire soit aux pôles magnétiques (intensité magnétique maximale), soit entre deux aimants de même polarité (intensité magnétique minimale nulle). Ces zones de convergence des lignes de champ magnétique sont appelées "*festons*" (ou *"cusps"* en anglais).

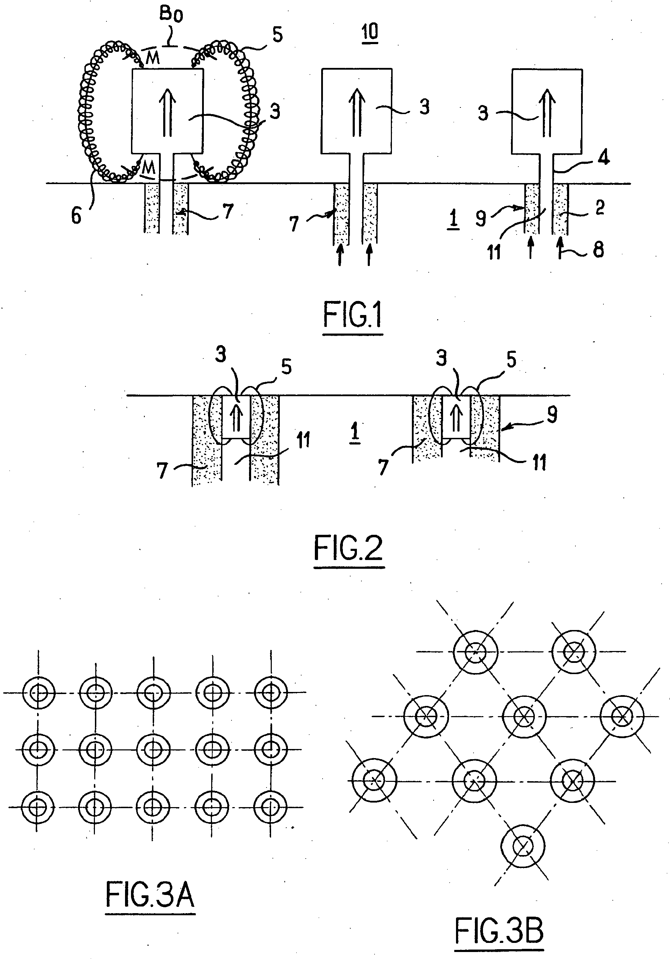

Les électrons énergiques qui produisent le plasma (dits électrons rapides ou primaires) sont peu sensibles au champ électrique auto-consistant produit par la charge d'espace du plasma. Une fois piégés dans le champ magnétique $B_0$, comme le montre la Fig. 1, dans l'intervalle entre deux collisions élastiques ou inélastiques, les électrons 6 oscillent entre deux points miroir M (où l'intensité du champ magnétique est identique). Les points miroir M sont situés face à deux pôles magnétiques opposés des aimants 3. Les électrons 6 oscillent entre les points M en s'enroulant autour d'une ligne de champ moyenne 5. Leurs trajectoires restent inscrites entre deux lignes de champ magnétique d'intensité constante.

Contrairement aux électrons rapides précités - peu sensibles au champ électrique du plasma comme on l'a dit - , les ions et les électrons peu énergiques du plasma (dits électrons lents ou thermiques), qui oscillent, eux aussi, entre deux pôles magnétiques opposés, sont eux sensibles au champ électrique du plasma et diffusent dans le champ magnétique de façon collective, sous l'influence de ce champ électrique.

Enfin, en dehors de ces mouvements d'oscillation et de diffusion, les particules chargées dérivent le long ou autour des aimants, perpendiculairement au plan qui contient le vecteur du champ magnétique généré par la structure magnétique. C'est pour cette raison qu'il est hautement préférable de refermer sur elles-mêmes les structures de champ magnétique (structures de type magnétron, en anneau, en peigne ou en piste) afin d'éviter les pertes de particules chargées aux extrémités des structures magnétiques continues.

Dans les structures de confinement magnétique multipolaire, le plasma était produit à l'origine par des électrons émis par des filaments thermo-émissifs situés à l'intérieur de la structure de confinement et polarisés négativement par rapport à l'enceinte et à la structure magnétique.

En fait, le plasma peut aussi être produit dans l'enceinte ou à sa périphérie par tout moyen ou méthode appropriés. En fait, tout type d'excitation du plasma est envisageable, quelle que soit la fréquence d'excitation et le mode d'excitation (Résonance Cyclotronique Electronique (ou RCE), décharge continue, décharge continue pulsée, décharge basse fréquence BF, décharge radiofréquence RF, onde de surface, décharge inductive, décharge magnétron, etc.).

Il est même possible d'utiliser les structures magnétiques de confinement pour exciter le plasma, soit par application à la structure d'une tension négative continue ou continue pulsée, d'une tension BF ou RF, soit par l'application de micro-ondes pour une excitation de type résonance électronique cyclotronique distribuée (RCED).

• Un des moyens pour confiner et produire des plasmas de grandes dimensions entretenus par champs HF, principalement dans la gamme des micro-ondes (typiquement au dessus de la centaine de MHz), est de distribuer des sources élémentaires selon des réseaux à deux ou trois dimensions.

Des sources de plasma micro-ondes distribuées selon un réseau bi-dimensionnel permettent de réaliser des sources planes (ou gauches de grandes dimensions), tandis que des sources distribuées selon un réseau tri-dimensionnel permettent, à titre d'exemples non limitatifs, de produire des volumes de plasma, par exemple dans un réacteur de géométrie cylindrique ou sphérique.

Des exemples de dispositifs sont divulgués dans FR 2 797 372, FR 2 838 020, et FR 2 840 451.

FR 2 797 372 et FR 2 838 020 divulguent des dispositifs permettant de produire, à basse pression (de $10^{-2}$ à quelques pascal), des plasmas plans ou cylindriques à partir de sources élémentaires entretenues par micro-ondes à la résonance cyclotronique électronique (RCE). La production du plasma par RCE requiert la présence d'un champ magnétique qui permet de définir des régions où la fréquence $f_0$ du champ électrique micro-onde appliqué est égale à la fréquence de giration des électrons dans le champ magnétique d'amplitude $B_0$, soit

$$f_0 = eB_0/2\pi m_e \qquad (1)$$

où $m_e$ est la masse de l'électron.

Dans FR 2 797 372 et FR 2 838 020, le champ magnétique est produit par un aimant permanent (dipôle magnétique) fixé à l'extrémité d'un applicateur micro-onde coaxial. Pour cette raison, ces types de plasma sont appelés plasmas multi-dipolaires. En particulier, et comme le montre la Fig. 1, FR 2 838 020 enseigne de disposer des aimants permanents 3 à distance des parois 1, grâce à des tiges 4, pour éviter que les trajectoires 6 des électrons ne coupent les parois 1 et donc qu'ils soient collectés sur ces surfaces.

La figure 1 montre que FR 2 838 020 propose une solution satisfaisante au niveau du confinement du plasma 10 puisque aucune ligne de champ 5 ne rencontre de surface ou une paroi 1, évitant ainsi des pertes directes d'électrons sur les parois.

Par contre, la production de plasma par RCE, telle que décrite dans FR 2 797 372 et FR 2 838 020, présente des inconvénients majeurs en fonction des conditions opératoires des sources élémentaires, à savoir :

1) le plasma 10 est produit préférentiellement sur la partie cylindrique autour de l'aimant 3, et non pas sur la face avant de l'aimant, comme c'est préférable dans de nombreuses applications ;

2) le domaine de pression de cette technique est limité aux basses pressions, typiquement au pascal (10 mtorr), car, aux pressions supérieures, le plasma est alors essentiellement produit sur la face arrière de l'aimant 3, et non face avant, côté utilisation. La technique de production de plasma reste donc limité au domaine des basses pressions ;

3) dans le cas d'une source de plasma non plane (réacteur cylindrique), le fait de mettre les aimants permanents à distance des parois réduit le volume utile, de plasma dans le réacteur.

Comme le montre la Fig. 2, FR 2 840 451 divulgue quant à lui une source de plasma 10 plane où les micro-ondes sont appliquées au plasma par des applicateurs 9 de propagation coaxiaux se terminant selon une section droite. Ces applicateurs 9 étant généralement distribués selon un réseau carré, ces types de plasma 10 sont appelés des plasmas matriciels. A priori, le domaine de pression visé (10 à $10^3$ pascal) ne requiert pas de champ magnétique, mais FR 2 840 451 enseigne la possibilité de disposer un aimant 3 dans l'âme centrale 11 de l'applicateur. Dans ce cas, les lignes 5 de champ magnétique se re-bouclent nécessairement sur des parois 1 métalliques ou diélectriques de l'enceinte. Dans ce cas, les électrons accélérés à la RCE sont tous collectés sur l'applicateur coaxial 9, ce qui est catastrophique sur le plan du bilan de puissance du plasma. Le confinement du plasma est inefficace, l'aimant 3 servant uniquement à fournir les conditions de RCE indispensables pour obtenir le claquage du plasma 10 aux basses pressions (de l'ordre de un pascal à quelques dizaines de pascal).

US-A-6 022 446 divulgue un dispositif de confinement comportant, sur une paroi, des aimants à aimantation radiale, mais dans lequel les aimants sont concentriques les uns par rapport aux autres. Cette structure impose l'utilisation d'au moins deux couronnes d'aimants, avec une configuration magnétique compliquée, et est très mal adaptée à un confinement ne présentant pas de symétrie de révolution, et ne se prête pas à la réalisation de réseaux bi ou tri-dimensionnels.

PRESENTATION DE L'INVENTION

L'invention a pour but de résoudre au moins un des inconvénients précités.

A cet effet, on propose selon l'invention un dispositif de production et/ou de confinement d'un plasma selon la revendication 1.
L'invention est avantageusement complétée par les caractéristiques des revendications 2 à 10.

L'invention concerne également un procédé de production et/ou de confinement d'un plasma selon les revendications 11 ou 12.

L'invention présente de nombreux avantages.

L'invention permet un confinement de plasmas denses de grandes dimensions, depuis les plus basses pressions ($10^{-2}$ pascal ou moins) jusqu'à la dizaine de pascal (pression à laquelle le confinement magnétique devient inefficace). On peut ainsi opérer dans un large domaine de pression, soit avec un couplage RCE, soit avec un couplage par absorption collisionnelle lorsque le champ magnétique devient inopérant, c'est-à-dire lorsque la fréquence $\nu$ de collisions élastiques des électrons devient grande devant la pulsation $\omega_0 = 2\pi f_0$ du champ électrique micro-onde ($\nu \gg \omega_0$), égale, à la RCE, à la pulsation électronique cyclotronique $\omega_c$ ($\omega_0 = \omega_c$).

L'invention proposée peut trouver des applications très nombreuses, en particulier dans le domaine des traitements de surface, comme la gravure, les dépôts (PACVD ou PAPVD), l'implantation ionique par immersion plasma, pour ne citer que quelques exemples.

L'invention permet la production de plasma dans le domaine de pression allant de $10^{-3}$ à quelques $10^3$ pascal, c'est-à-dire de l'ordre de $10^{-5}$ à 10 torr (1 torr = 133 pascal) en vue d'applications :

- aux traitements de surfaces (nettoyage, stérilisation, gravure, dépôt, implantation ionique, etc.),
- à la production d'espèces nouvelles (atomes, radicaux, métastables, espèces chargées, photons),
- à la réalisation de sources d'ions pour toute application nécessitant des faisceaux d'ions (sources d'ions mono- ou multi-chargés), ainsi que
- à tout domaine nécessitant la production, sur de grandes surfaces ou de grands volumes, de plasma uniforme.

Un autre avantage apporté par l'invention est la possibilité de réaliser une structure de confinement où les lignes de champ magnétique sont toutes situées dans le même demi-espace, d'où un confinement idéal du plasma dans le domaine des basses pressions.

En effet, avec ce type de configuration magnétique, les lignes de champ ne traversent jamais le plan médian de l'aimant et les zones RCE entourent généralement l'aimant, ce qui permet de pallier les inconvénients de l'état de l'art, à savoir :

1) les lignes de champ ne traversent aucune surface ou paroi, et donc les électrons piégés autour de ces lignes de champ restent bien confinés;
2) si l'aimant présente une aimantation suffisante, les conditions de RCE et les lignes de champ sont situées sur la face avant de la structure coaxiale, d'où une production du plasma vers le volume utile.

Il n'y a de plus aucune diminution du volume utile de plasma dans le réacteur, car le dispositif ne comporte avantageusement pas de tiges supportant les aimants vers l'intérieur de l'enceinte.

Un autre avantage apporté par l'invention est l'extension d'échelle du confinement et de la production de plasma. En effet, il n'y a pas de limitation théorique, voire technologique, à augmenter le nombre d'applicateurs, soit sur une surface plane, soit sur une surface non plane, par exemple cylindrique. Il est possible d'alimenter en puissance micro-onde autant d'applicateurs que souhaités par autant de générateurs indépendants que nécessaires, avec ou sans division de puissance. Chaque applicateur peut être alimenté à l'aide d'un câble coaxial puisque la puissance micro-onde nécessaire à chaque applicateur est relativement faible, d'où la grande fiabilité du dispositif global.

Un autre avantage est la possibilité de produire des plasmas denses dans toute la gamme de pression définie dans l'invention, depuis $10^{-2}$ pascal jusqu'à $10^3$ pascal avec le même applicateur, et avec une efficacité de couplage maximum. En effet, grâce à l'invention, il est possible d'entretenir le plasma aussi bien dans le régime de RCE (couplage résonnant) que dans le domaine hors RCE, à plus haute pression (couplage par absorption collisionnelle).

Un autre avantage est que, pour des aimants du commerce et des conditions opératoires conventionnelles (par exemple, une fréquence micro-onde $f_0 = 2{,}45$ GHz), les lignes d'intensité de champ magnétiques $B_0$ entourent complètement l'aimant annulaire de telle sorte que les micro-ondes ne peuvent pas rayonner en dehors de la zone de l'applicateur sans traverser une zone de couplage RCE, d'où un couplage optimum des micro-ondes avec un plasma à basse et très basse pression.

Pour la RCE, il est possible d'utiliser des fréquences micro-ondes (5,8 GHz, 2,45 GHz, 920 MHz), mais aussi des fréquences plus basses (jusqu'à la centaine de MHz). Ainsi, la possibilité d'utiliser des fréquences bien plus basses que 2,45 GHz permet d'envisager, pour chaque source élémentaire, des alimentations unitaires par transistors de puissance.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

les figures 1 et 2, déjà commentées, représentent schématiquement des montages selon l'art antérieur;

les figures 3A et 3B représentent schématiquement deux exemples possibles de réseaux bi-dimensionnels;

les figures 4A et 4B représentent schématiquement respectivement une vue en coupe et une vue de face d'un mode de réalisation possible de l'invention;

les figure s 5A à 5C représentent schématiquement des coupe s de modes de réalisation possibles d'un applicateur selon l'invention; et

les figures 6A à 6C représentent schématiquement des exemples de modes de réalisation possibles d'un aimant annulaire ;

les figure s 7A et 7B représentent schématiquement respectivement une vue en coupe et une vue de face d'un mode de réalisation possible de l'invention comportant un matériau de fer doux ;

la figure 8 représente schématiquement une vue en coupe d'un mode de réalisation possible de l'invention, dans lequel le fer doux des figures 7A et 7B est remplacé, sur la périphérie interne et/ou externe, par des anneaux aimants de polarisation opposée de manière à conserver de préférence une symétrie par rapport au plan médian de l'aimant ;

la figure 9 montre un mode de réalisation dans lequel l'aimant annulaire est situé sur l'âme centrale de l'applicateur coaxial au lieu d'être situé en périphérie de l'applicateur coaxial.

Dans toutes les figures, les éléments similaires portent des références numériques identiques.

DESCRIPTION DETAILLEE

Afin de conférer à une structure magnétique multipolaire une grande efficacité de confinement et/ou de production pour les plasmas, on propose selon l'invention de faire en sorte que les trajectoires des particules chargées issues du plasma et piégées autour d'une ligne de champ magnétique ne rencontrent pas de parois (pertes par le mécanisme 3).

Pour cela, il faut que les trajectoires des électrons piégés soient libres de tout obstacle entre deux points miroir M d'égale intensité de champ magnétique.

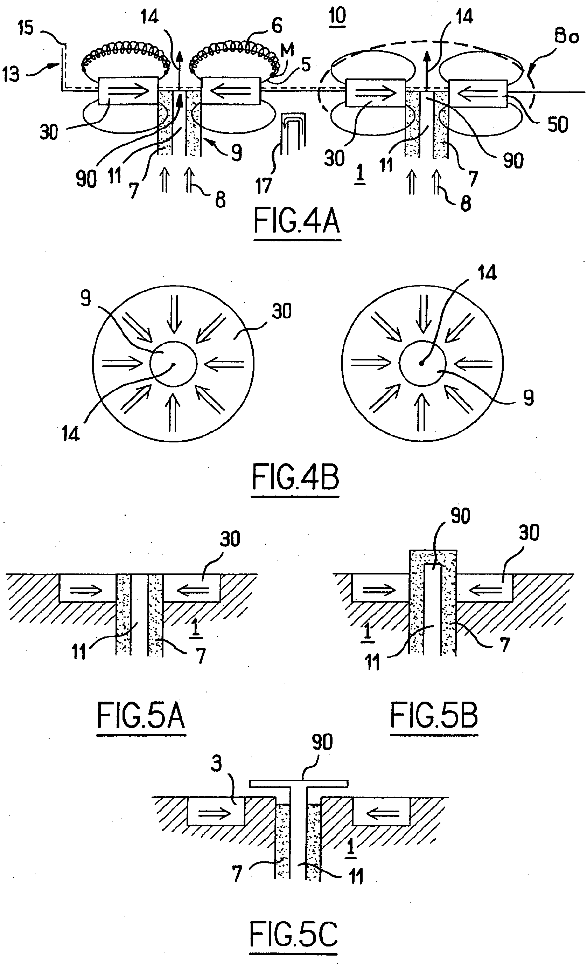

On propose ainsi selon l'invention un dispositif de production et/ou de confinement d'un plasma 10, visible plus particulièrement aux figures 4A et 4B.

Le dispositif comporte principalement une enceinte 13 dans le volume de laquelle le plasma 10 est produit ou confiné.

L'enceinte 13 comprend une paroi 1 définissant une enveloppe 15 intérieure à l'enceinte et englobant le volume.

Dans la suite de la présente description, on appelle « enceinte » le récipient dans le volume duquel le plasma 10 est produit ou confiné, un même dispositif pouvant ainsi être divisé en plusieurs enceintes, par exemple par des cloisons internes ou des parois supplémentaires séparant le dispositif.

Le dispositif comporte au moins un aimant annulaire 30, centré sur une normale 14 à l'enveloppe.

L'aimant annulaire 30 est de direction d'aimantation radiale. Il est en outre arrangé à proximité de la paroi 1 définissant l'enveloppe 15 supportant la normale 14, de sorte que la direction d'aimantation soit sensiblement perpendiculaire à ladite normale 14 à l'enveloppe 15.

Une telle configuration de l'aimant annulaire permet de réaliser un confinement du plasma, sans que les trajectoires 6 des électrons piégés ne rencontrent une paroi 1 de l'enceinte.

D'une façon générale, l'aimant annulaire comporte principalement une aimantation radiale, mais aussi une symétrie par rapport à un plan parallèle à la direction d'aimantation radiale, que l'on pourra appeler un plan médian de l'aimant.

Pour réaliser une production de plasma 10, le dispositif comporte en outre au moins une source élémentaire de plasma comportant un applicateur coaxial 9 de micro-ondes.

L'applicateur 9 traverse la paroi 1 de l'enceinte et comprend une âme centrale 11.

L'aimant annulaire 30 est centré sur l'âme centrale 11 de l'applicateur 9. L'aimant annulaire 30 à aimantation radiale est placé autour d'une extrémité libre 90 de l'applicateur coaxial d'amenée des micro-ondes.

Dans le cas de confinement et/ou de production, seules les lignes de champ magnétique 5 à l'avant d'un plan longitudinal médian 50 de l'aimant 30 sont situées côté plasma 10, comme le montrent les Fig. 4A et 4B.

En effet, le dispositif des Fig. 4A et 4B notamment permet de résoudre les difficultés de l'art antérieur. En effet, le plasma est confiné de manière efficace. Il peut être produit face à l'applicateur 9 . De plus, le champ magnétique B0 ne perturbe pas le couplage par absorption collisionnelle, qui prend le relais de la RCE lorsque la pression augmente. En effet, la configuration des lignes 5 de champ de l'aimant permanent 30 font que ces dernières vont d'un pôle au pôle opposé sans jamais traverser le plan médian 50 de l'aimant 30.

L'applicateur coaxial 9 comporte un matériau diélectrique 7 disposé autour de l'âme centrale 11 , au niveau de la paroi 1 de l'enceinte. Le matériau diélectrique 7 peut bien entendu être disposé au dessous du niveau de la paroi, comme indiqué sur la figure 5C, ou au-dessus de la paroi 1. Le matériau 7 est ainsi disposé sur une partie au moins de la longueur de l'applicateur 9.

Un dispositif selon l'invention, pour réaliser un dispositif de confinement d'un plasma 10 de grandes dimensions, comporte, selon des réseaux bi- ou tri-dimensionnels, une pluralité d'aimants 30 annulaires à aimantation radiale, disposés à la périphérie du plasma 10.

Les aimants ne sont pas concentriques entre eux, de sorte que les lignes de champ magnétique se rebouclent sur le pôle opposé du même aimant. Ainsi les lignes de champ, qui ne traversent pas le plan médian de l'aimant, ne traversent aucune paroi de l'enceinte. En d'autres termes, les aimants sont externes les uns aux autres, pour former les réseaux précités.

Il peut également comporter une pluralité de sources élémentaires comportant chacune un applicateur 9.

Chaque réseau bi ou tri dimensionnel est par exemple rectangulaire ou carré, comme le montre la figure 3A, ou hexagonal, comme le montre la Fig. 3B.

Ainsi, pour des sources élémentaires distribuées selon des réseaux bi-ou tri-dimensionnels, le dispositif présente une structure magnétique :

- d'une part générant, par RCE (c'est-à-dire capable de délivrer le champ magnétique d'intensité $B_0$ nécessaire au couplage RCE), un plasma 10 essentiellement dans la direction face aux applicateurs 9, et,

- d'autre part permettant, suivant la forme de l'extrémité libre 90 de l'applicateur 9, un fonctionnement dans un large domaine de pressions, soit par couplage RCE du champ électrique micro-onde avec les électrons (couplage résonnant), soit, à plus haute pression, par couplage par absorption collisionnelle, lorsque le champ magnétique devient inopérant.

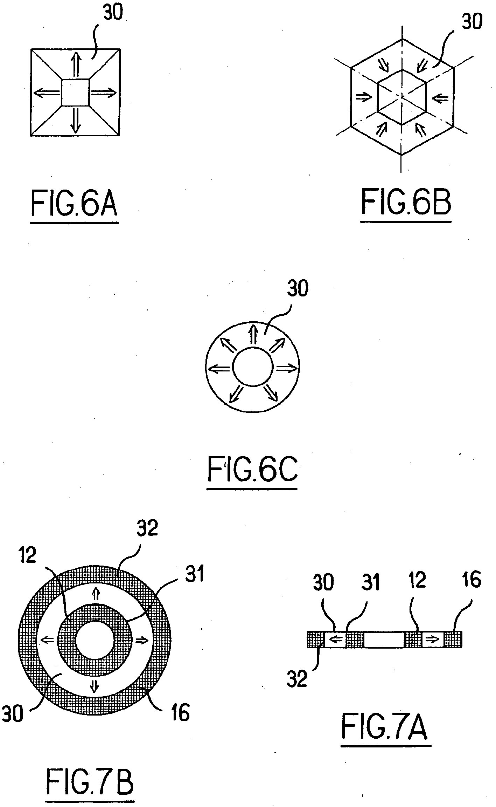

Les aimants 30 distribués suivant des réseaux bi- ou tri-dimensionnels peuvent présenter tous le même sens d'aimantation radiale par rapport aux parois 1 ou aux applicateurs 9 qu'ils entourent, soit des sens alternés. Autrement dit, l'aimantation radiale peut être centripète (voir par exemple figure 6B) pour tout ou partie des aimants 30, et/ou centrifuge (voir par exemple figure 6A) pour tout ou partie des aimants 30.

De même, seule une partie des aimants 30 annulaires (un aimant 30 sur deux, ou une rangée sur deux d'aimants 30, à titre d'exemples non limitatifs) peuvent être alimentés en micro-ondes par un applicateur 9.

Comme le montre la figure 4A, l'aimant annulaire 30 est au moins partiellement en contact avec la paroi 1 de l'enceinte. L'aimant 30 peut ainsi être encastré dans la paroi 1 de l'enceinte jusqu'à un plan médian 50 de l'aimant 30. L'extrémité libre 90 de l'âme centrale 11 affleure avec le niveau de la paroi de l'enceinte.

L'invention peut présenter de nombreuses variantes par rapport à la configuration proposée sur les Fig s. 4A et 4B. Ces variantes concernent notamment la position de l'aimant 30 par rapport à l'applicateur coaxial 9, et/ou la forme de l'extrémité libre 90 de l'applicateur.

La figure 5A montre que l'aimant 30 peut être totalement encastré dans la paroi 1 de l'enceinte. Dans ce cas, les surfaces de la paroi 1, de l'aimant 30, du matériau diélectrique 7 et de l'âme centrale 11 sont au même niveau.

La figure 5B montre que l'âme centrale 11 peut dépasser du niveau de la paroi 1. Dans ce cas également, le matériau 7 diélectrique peut entourer l'âme 11 centrale et recouvrir l'extrémité libre 90 de l'applicateur 9.

La figure 5C montre que l'extrémité libre 90 de l'applicateur peut avoir une section droite plus importante que la section droite de l'âme centrale 11. Dans ce cas, le diamètre interne de l'aimant 30 est supérieur au diamètre externe de l'extrémité libre 90.

Les aimants 30 peuvent également être uniquement en contact avec la paroi 1, ou être un peu au-dessus du niveau de la paroi 1, sur des supports.

Ces variantes, présentées à titre d'exemples non limitatifs, permettent l'optimisation des sources de plasma élémentaires en fonction de l'application ou du procédé visés (simple confinement du plasma ou confinement et production de plasma, domaine de pression utile, etc.). En particulier, pour éviter, dans certaines conditions opératoires, le couplage du plasma dans la structure coaxiale, il est souvent préférable, comme on l'a vu, d'utiliser un applicateur rempli totalement ou partiellement de matériau diélectrique 7.

Les aimants 30 à aimantation radiale peuvent aussi présenter des formes variées. Comme le montrent les figures 4B et 6C, l'aimant annulaire 30 peut être circulaire. Les figures 6A et 6B montrent que l'aimant 30 peut également être polygonal, comme carré (figure 6A), hexagonal (figure 6B), octogonal, décagonal... Mais la forme annulaire circulaire est de loin la plus commune et la plus simple à mettre en oeuvre.

Les figures 7A et 7B montrent que l'aimant 30 présente une périphérie interne 31 et une périphérie externe 32.

Avantageusement, l'aimant 30 est entouré sur sa périphérie interne 31 et/ou externe 32 par un matériau à forte perméabilité magnétique, par exemple sous forme d'anneaux 12 et/ou 16. Les anneaux 12 et/ou 16 sont par exemple des anneaux de fer doux. Le matériau à forte perméabilité magnétique permet d'ajuster la configuration des lignes 5 de champ au niveau des pôles magnétiques de l'aimant 30.

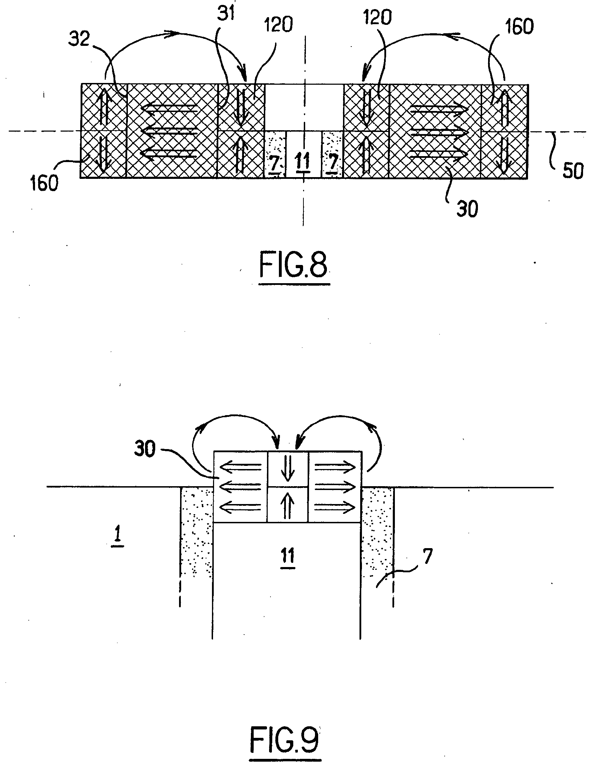

Comme le montrent la figure 8, avantageusement, l'aimant 30 est entouré sur sa périphérie interne 31 et/ou externe 32 par des anneaux aimants 120 et /ou 160. Les anneaux aimants 120 et/ou 160 ont des directions d'aimantation axiales et non pas radiales qui permettent de ramener les pôles, et donc les lignes de champ, au dessus et au dessous des plans supérieur et inférieur de l'aimant annulaire 30.

De plus, la figure 9 montre que, dans le cas où l'âme centrale 11 de l'applicateur coaxial est très large, l'aimant annulaire 30 (autre exemple) peut être situé sur ladite âme au lieu d'être situé à l'extérieur de la structure coaxiale.

Bien entendu, le confinement et la production de plasmas très denses (au-delà de $10^{10}$ cm$^{-3}$) nécessi-

tent le refroidissement des structures magnétiques et coaxiales, par exemple par une circulation 17 d'un fluide caloporteur gazeux ou liquide.

Avec la technologie décrite, il est possible de réaliser soit des sources planes de grandes dimensions, soit des sources et/ou enceintes cylindriques ou sphériques, suivant l'application visée.

La fréquence micro-onde utilisée n'est pas critique, et il est donc possible d'utiliser l'une des fréquences ISM comme le 915 MHz ou le 2,45 GHz, voire 5.8 GHz. Pour une excitation du plasma à la résonance cyclotronique électronique par des micro-ondes à 2,45 GHz, la condition de résonance ($B_0$=0,0875 tesla) est facilement remplie par des aimants permanents conventionnels, comme en samarium-cobalt, voire en ferrite de baryum ou en ferrite de strontium. C'est encore plus le cas à 100, 200 ou 300 MHz, où le coût des transistors de puissance est bien plus faible qu'à 915 MHz ou 2,45 GHz. Les fréquences données à titre d'exemple ne sont bien entendu pas limitatives.

## Revendications

1. Dispositif de production et/ou de confinement d'un plasma (10), comportant

   - une enceinte (13) dans le volume de laquelle le plasma est produit ou confiné, ladite enceinte comprenant une paroi (1) définissant une enveloppe (15) intérieure à l'enceinte et englobant le volume,
   - une pluralité d'aimants annulaires (30), centrés sur une normale (14) à l'enveloppe, de direction d'aimantation radiale et arrangés à proximité de la paroi (1) définissant l'enveloppe supportant la normale, de sorte que la direction d'aimantation soit sensiblement perpendiculaire à ladite normale à l'enveloppe ;

   **caractérisé en ce que** lesdits aimants annulaires (30) sont arrangés de manière non concentrique au niveau de la paroi pour former un réseau bi-dimensionnel ou tri-dimensionnel.

2. Dispositif selon la revendication 1, dans lequel le réseau est carré ou hexagonal.

3. Dispositif selon l'une des revendications 1 ou 2, comportant en outre au moins une source élémentaire de plasma comportant un applicateur coaxial (9) de micro-ondes comprenant une âme centrale (11), l'applicateur (9) traversant la paroi (1) de l'enceinte, un aimant annulaire (30) étant en outre centré sur l'âme centrale (11) de l'applicateur.

4. Dispositif selon l'une des revendications 1 à 3, dans lequel chaque aimant annulaire (30) est au moins partiellement en contact avec la paroi de l'enceinte.

5. Dispositif selon l'une des revendications 1 à 4, dans lequel l'applicateur coaxial comporte un matériau diélectrique (7) disposé autour de l'âme centrale (11), au moins sur une partie de la longueur de l'applicateur.

6. Dispositif selon l'une des revendications 1 à 5, dans lequel chaque aimant annulaire (30) est circulaire ou polygonal.

7. Dispositif selon l'une des revendications 1 à 6, dans lequel chaque aimant annulaire (30) présente une périphérie interne (31) et une périphérie externe (32), l'aimant étant entouré sur sa périphérie interne et/ou externe par un matériau à forte perméabilité magnétique.

8. Dispositif selon l'une des revendications 3 à 7, dans lequel chaque aimant délivre un champ magnétique d'intensité $B_0$ telle que la fréquence $f_0$ d'un champ électrique des micro-ondes appliquées par un applicateur est égale à une fréquence f de giration d'électrons dans le champ magnétique, soit :

$$f = f_0 = eB_0/2\pi m_e,$$

où $m_e$ est la masse d'un électron,
pour permettre la production du plasma à basse pression, par résonance cyclotronique électronique.

9. Dispositif selon l'une des revendications 3 à 8, dans lequel l'aimant annulaire (30) est disposé à l'extérieur de l'applicateur coaxial.

10. Dispositif selon l'une des revendications 3 à 8, dans lequel l'aimant annulaire (30) est disposé sur l'âme centrale de l'applicateur coaxial.

11. Procédé de production et/ou de confinement d'un plasma (10) dans une enceinte, ladite enceinte comprenant une paroi (1) définissant une enveloppe intérieure à l'enceinte et englobant un volume, comportant une étape consistant à arranger une pluralité d'aimants annulaires (30), centrés sur une normale à ladite enveloppe, de direction d'aimantation radiale à proximité de la paroi (1) définissant l'enveloppe supportant la normale, de sorte que la direction d'aimantation soit sensiblement perpendiculaire à ladite normale à l'enveloppe ;
**caractérisé en ce qu'**il comporte une étape consistant à
arranger lesdits aimants annulaires (30) de manière non concentrique au niveau de la paroi pour former un réseau bi-dimensionnel ou tri-dimensionnel.

12. Procédé selon la revendication 11, comportant en outre au moins une étape consistant à produire le plasma grâce à au moins une source élémentaire de plasma comportant un applicateur coaxial (9) de microondes comprenant une âme centrale (11), l'applicateur (9) traversant la paroi (1) de l'enceinte, un aimant annulaire (30) étant en outre centré sur l'âme centrale (11) de l'applicateur.

**Patentansprüche**

1. Vorrichtung zum Herstellung und/oder Einschließen eines Plasmas (10), umfassend

   - ein Gehäuse (13), in dessen Volumen das Plasma erzeugt oder eingeschlossen wird,
   - wobei das Gehäuse eine Wand (1) umfasst, die eine innere Hülle (15) des Gehäuses bildet und das Volumen aufnimmt,
   - eine Vielzahl von ringförmigen Magneten (30), die auf einer Normalen (14) zur Hülle zentriert sind, mit radialer Magnetisierungsrichtung und angeordnet in der Nähe der Wand (1), die die Hülle definiert, die die Normale stützt, so dass die Magnetisierungsrichtung im Wesentlichen senkrecht zur Normalen zur Hülle ist;

   **dadurch gekennzeichnet, dass** die ringförmigen Magneten (30) auf nicht konzentrische Weise auf der Ebene der Wand angeordnet sind, um ein bidimensionales oder tridimensionales Netz zu bilden.

2. Vorrichtung nach Anspruch 1, wobei das Netz quadratisch oder sechseckig ist.

3. Vorrichtung nach einem der Ansprüche 1 oder 2, umfassend außerdem eine elementare Plasmaquelle, die eine koaxiale Anwendungsvorrichtung (9) von Mikrowellen umfasst, umfassend einen zentralen Kern (11), wobei die Anwendungsvorrichtung (9) die Wand (1) des Gehäuses durchquert, wobei ein ringförmiger Magnet (30) außerdem auf dem zentralen Kern (11) der Anwendungsvorrichtung zentriert ist.

4. Vorrichtung nach einem der Ansprüche 1 bis 3, wobei jeder ringförmige Magnet (30) mindestens teilweise mit der Wand des Gehäuses in Kontakt steht.

5. Vorrichtung nach einem der Ansprüche 1 bis 4, wobei die koaxiale Anwendungsvorrichtung ein dielektrisches Material (7) umfasst, das um den zentralen Kern (11) angeordnet ist, mindestens auf einem Teil der Länge der Anwendungsvorrichtung.

6. Vorrichtung nach einem der Ansprüche 1 bis 5, wobei jeder ringförmige Magnet (30) rund oder polygonal ist.

7. Vorrichtung nach einem der Ansprüche 1 bis 6, wobei jeder ringförmige Magnet (30) einen inneren Umfang (31) und einen äußeren Umfang (32) aufweist, wobei der Magnet auf seinem inneren und/oder äußeren Umfang von einem Material mit starker magnetischer Durchlässgikeit umgeben ist.

8. Vorrichtung nach einem der Ansprüche 3 bis 7, wobei jeder Magnet ein Magnetfeld mit der Intensität $B_0$ liefert, so dass die Frequenz $f_0$ eines elektrischen Felds der Mikrowellen, die von einer Anwendungsvorrichtung angewendet werden, gleich einer Frequenz f der Elektronengyration auf dem Magnetfeld ist, d.h.

$$f = f_0 = eB_0/2\pi m_e,$$

wobei $m_e$ die Masse eines Elektrons ist, um die Erzeugung des Plasmas mit niedrigem Druck durch Elektronenzyklonresonanz zu ermöglichen.

9. Vorrichtung nach einem der Ansprüche 3 bis 8, wobei der ringförmige Magnet (30) außerhalb der koaxialen Anwendungsvorrichtung angeordnet ist.

10. Vorrichtung nach einem der Ansprüche 3 bis 8, wobei der ringförmige Magnet (30) auf dem zentralen Kern der koaxialen Anwendungsvorrichtung angeordnet ist.

11. Verfahren zum Herstellen und/oder Einschliessen eines Plasmas (10) in einem Gehäuse, wobei das Gehäuse eine Wand (1) umfasst, die eine innere Hülle des Gehäuses definiert und ein Volumen aufnimmt, umfassend einen Schritt, der aus Folgendem besteht:

    - Anordnen einer Vielzahl von ringförmigen Magneten (30), zentriert auf einer Normalen zu der Hülle, mit radialer Magnetisierungsrichtung in der Nähe der Wand (1), die die Hülle definiert, die die Normale stützt, so dass die Magnetisierungsrichtung im Wesentlichen senkrecht zur Normalen zur Hülle ist;

    **dadurch gekennzeichnet, dass** es einen Schritt umfasst, der aus Folgendem besteht:

    Anordnen der ringförmigen Magneten (30) auf nicht konzentrische Weise auf der Ebene der Wand, um ein bidimensionales oder tridimensionales Netz zu bilden.

**12.** Verfahren nach Anspruch 11, umfassend außerdem mindestens einen Schritt, der darin besteht, das Plasma dank mindestens einer elementaren Plasmaquelle zu erzeugen, die eine koaxiale Anwendungsvorrichtung (9) von Mikrowellen umfasst, umfassend einen zentralen Kern (11), wobei die Anwendungsvorrichtung (9) die Wand (1) des Gehäuses durchquert, und wobei ein ringförmiger Magnet (30) außerdem auf dem zentralen Kern (11) der Anwendungsvorrichtung zentriert ist.

## Claims

**1.** Device for producing and/or confining a plasma (10) comprising

   - a chamber (13) in the volume of which the plasma is produced or confined,
   said chamber including a wall (1) defining an envelope (15) inside the chamber and surrounding the volume,
   - a plurality of annular magnets (30), centered on a normal (14) to the envelope, having a radial magnetization direction and arranged near the wall (1) defining the envelope supporting the normal, so that the magnetization direction is substantially perpendicular to said normal to the envelope;

   **characterized in that** said annular magnets (30) are arranged in a non-concentric manner at the level of the wall in order to form a two- or three-dimensional array.

**2.** Device according to claim 1, wherein the array is square or hexagonal.

**3.** Device according to one of claims 1 or 2, further comprising at least one elementary plasma source comprising a coaxial microwave applicator (9) including a central core (11), the applicator (9) passing through the wall (1) of the chamber, and an annular magnet (30) further being centered on the central core (11) of the applicator.

**4.** Device according to one of claims 1 to 3, wherein each annular magnet (30) is at least partially in contact with the wall of the chamber.

**5.** Device according to one of claims 1 to 4, wherein the coaxial applicator comprises a dielectric material (7) placed around the central core (11), at least over a portion of the length of the applicator.

**6.** Device according to one of claims 1 to 5, wherein each annular magnet (30) is circular or polygonal.

**7.** Device according to one of claims 1 to 6, wherein each annular magnet (30) has an internal periphery (31) and an external periphery (32), the magnet being surrounded on its internal and/or external periphery by a material with high magnetic permeability.

**8.** Device according to one of claims 3 to 7, wherein each magnet generates a magnetic field of intensity $B_0$ such that the frequency $f_0$ of an electric field of the microwaves applied by an applicator is equal to a frequency f of gyration of electrons in the magnetic field, i.e.:

$$f = f_0 = eB_0/2\pi m_e,$$

where $m_e$ is the mass of an electron,
in order to enable the production of plasma at low pressure by electron cyclotron resonance.

**9.** Device according to one of claims 3 to 8, wherein the annular magnet (30) is arranged outside the coaxial applicator.

**10.** Device according to one of claims 3 to 8, wherein the annular magnet (30) is arranged on the central core of the coaxial applicator.

**11.** Method for producing and/or confining a plasma (10) in a chamber, said chamber including a wall (1) defining an envelope inside the chamber and surrounding a volume,
comprising a step consisting of arranging a plurality of annular magnets (30), centered on a normal to said envelope, having a radial magnetization direction, near the wall (1) defining the envelope supporting the normal, so that the magnetization direction is substantially perpendicular to said normal to the envelope;
**characterized in that** it comprises a step consisting of arranging said annular magnets (30) in a non-concentric manner at the level of the wall in order to form a two- or three-dimensional array.

**12.** Method according to claim 11, further comprising at least one step consisting of producing the plasma with at least one elementary plasma source comprising a coaxial microwave applicator (9) including a central core (11), the applicator (9) passing through the wall (1) of the chamber, and an annular magnet (30) further being centered on the central core (11) of the applicator.

FIG.1

FIG.2

FIG.3A

FIG.3B

FIG.4A

FIG.4B

FIG.5A

FIG.5B

FIG.5C

FIG.6A

FIG.6B

FIG.6C

FIG.7B

FIG.7A

FIG.8

FIG.9

**EP 2 044 816 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2797372
- FR 2838020
- FR 2840451
- US 6022446 A